# FASCICULE DE BREVET EUROPEEN

(11) **EP 3 391 394 B1**
(45) Date de publication et mention de la délivrance du brevet: **29.07.2020**
(21) Numéro de dépôt: 16810405.7
(22) Date de dépôt: 16.12.2016
(51) Int. Cl.: H01F 27/26, H01F 37/00

(54) **DISPOSITIF ELECTRONIQUE COMPORTANT AU MOINS UNE INDUCTANCE COMPRENANT DES MOYENS DE GESTION THERMIQUE PASSIFS**
ELEKTRONISCHE VORRICHTUNG MIT MINDESTENS EINEM INDUKTOR MIT PASSIVER WÄRMEVERWALTUNGSVORRICHTUNG
ELECTRONIC DEVICE INCLUDING AT LEAST ONE INDUCTOR COMPRISING PASSIVE HEAT MANAGEMENT MEANS

(30) Priorité: 17.12.2015 FR 1562600
(43) Date de publication de la demande: 24.10.2018
(73) Titulaire: Commissariat à l'Energie Atomique et aux Energies Alternatives, 75015 Paris (FR)
(72) Inventeur: DELETTE, Gérard, 38100 Grenoble (FR); PERICHON, Pierre, 38500 Voiron (FR)
(74) Mandataire: Brevalex
(86) Numéro de dépôt international: PCT/EP2016/081391
(87) Numéro de publication internationale: WO 2017/103078

(56) Documents cités:
- EP-A1- 1 495 475
- EP-A1- 1 530 223
- EP-A1- 1 971 193
- EP-A1- 2 506 273
- EP-A2- 2 469 545
- WO-A1-2014/141670
- DE-U1-202014 105 157
- US-A- 4 603 314
- US-A1- 2006 097 831
- US-A1- 2007 139 151
- US-A1- 2012 306 605
- US-B1- 6 222 733
- US-B1- 6 392 519
- US-B1- 8 427 267

## Description

### DOMAINE TECHNIQUE ET ÉTAT DE LA TECHNIQUE ANTÉRIEURE

La présente invention se rapporte à un dispositif électronique comportant au moins une inductance magnétique comprenant des moyens de gestion thermique passifs, par exemple un convertisseur de puissance.

Dans le domaine de l'électronique de puissance, des inductances comportant un noyau ferromagnétique entouré au moins en partie par un bobinage conducteur électrique sont mis en œuvre en tant que composants passifs, principalement dans les convertisseurs de puissance. Les convertisseurs de puissance peuvent fonctionner à des fréquences comprises entre 100 kHz et 10 MHz et transmettre des puissances de 0,1 KW à 100 kW. Ces convertisseurs sont utilisés notamment dans le domaine de la production d'énergie, pour l'alimentation de moteurs électriques et de systèmes électroniques (appareils électroniques, ordinateurs portables). Dans ces domaines d'application, les inductances des convertisseurs ont des valeurs d'inductance comprises entre 1 µH et 10 mH.

Les inductances comprennent un noyau et un conducteur électrique, appelé bobinage, disposé selon N spires autour d'une partie du noyau. Le noyau comporte un matériau ferromagnétique. En fonctionnement, le bobinage est parcouru par un courant électrique alternatif générant une induction magnétique de même fréquence dans le noyau. Des pertes accompagnent la génération de l'induction magnétique, ce qui se traduit par des échauffements au sein du noyau magnétique. Ces pertes augmentent avec la fréquence de fonctionnement de l'inductance, nécessitant à partir de 1 MHz une gestion thermique pour refroidir le noyau afin d'éviter des élévations de températures rédhibitoires.

Un convertisseur de puissance est un dispositif électronique qui a pour fonction d'adapter la tension et le courant délivrés par une source de puissance électrique pour alimenter, selon les spécifications, un réseau de distribution ou un système électrique donné. Le convertisseur comprend des composants électroniques, dits composants actifs, fonctionnant comme des interrupteurs commutant à une fréquence donnée. Dans le cas des convertisseurs DC/DC par exemple, les composants actifs sont des transistors qui sont utilisés pour « découper » la tension d'entrée selon des cycles réguliers. Afin de délivrer une tension continue en sortie, des inductances sont utilisées pour stocker et déstocker l'énergie électrique sur chaque cycle et pour lisser la tension de sortie à sa valeur moyenne. Ces éléments dits « passifs » servent au fonctionnement des convertisseurs, mais ils peuvent représenter jusqu'à 40 % du volume et du coût du convertisseur.

Les fréquences de fonctionnement des convertisseurs se situent couramment dans la gamme 10kHz-500 kHz. Grâce à la technologie GaN, des transistors pouvant commuter à très haute fréquence, par exemple à une fréquence supérieure à 1 MHz peuvent être réalisés, ce qui permet de réalisation des convertisseurs à fréquence de fonctionnement augmentée.

D'une part, l'augmentation de la fréquence de fonctionnement devrait être particulièrement intéressante car elle permettrait de réduire le volume des composants passifs des convertisseurs donc l'encombrement, la masse et le coût de ces dispositifs. En augmentant la fréquence de découpage, le nombre de cycles électriques augmentent et ainsi l'énergie transférée par le noyau magnétique en un temps donné augmente dans la même proportion. Comme la puissance du convertisseur reste constante, on devrait pouvoir réduire le volume des inductances magnétiques de façon inversement proportionnelle à la fréquence.

Cette réduction de volume des noyaux magnétiques est particulièrement intéressante pour réaliser convertisseur de plus petite taille et de poids et de coût réduits. De tels convertisseurs sont souhaitables dans le secteur aéronautique et dans le secteur automobile.

D'autre part, les inductances compatibles avec des convertisseurs de puissance fonctionnant à des fréquences comprises entre 100 kHz et 10 MHz et des puissances de 0,1 KW à 100 kW sont caractérisées par des valeurs d'inductance L comprises entre 1 µH et 10 mH et des volumes supérieurs à 1 cm³. Dans cette gamme de convertisseurs, les inductances les mieux adaptées sont de type monolithique par opposition aux technologies basées sur des films minces ou des structures multicouches (LTCC) limitées à des puissances inférieures à 10 W.

Les inductances monolithiques sont constituées d'un matériau ferromagnétique monobloc formant leur noyau. Ce matériau est caractérisé par des valeurs élevées de perméabilité magnétique relative µr, par exemple supérieures à 50 et d'induction magnétique à saturation Bs, par exemple supérieures à 100 mT.

Les matériaux oxydes de type ferrite de structure cristallographique spinelle présentent des valeurs de perméabilité stables à haute fréquence. Pour cette raison, ils sont très largement utilisés comme noyaux d'inductance, notamment pour des fonctionnements à fréquence élevée (100 kHz < f < 10 MHz). Les formulations les plus courantes sont (Mn1-xZnxFe2O4) et (Ni1-xZnxFe2O4). Ces matériaux se caractérisent également par des valeurs de résistivité électrique élevées limitant les pertes par courants induits.

Malgré leur optimisation, ces matériaux ferromagnétiques sont le siège de processus de dissipation d'énergie appelés également pertes magnétiques. Ces pertes magnétiques sont dissipées sous forme de chaleur en tout point du volume du noyau. Ainsi, malgré la réduction du volume du noyau rendue possible par la montée en fréquence et permettant d'atteindre des puissances spécifiques de 100 W/cm³, il devient nécessaire de limiter la dissipation thermique au sein du noyau pour éviter une trop forte élévation de température dans le noyau.

D'autant plus que les pertes magnétiques augmentent avec la fréquence et avec la valeur crête de l'induction magnétique.

Par ailleurs, il a été montré qu'un volume de l'inductance réduit tend à produire davantage d'échauffement dans le noyau. Par exemple, un convertisseur de 1kW (200 V/400V) fonctionnant à 5MHz nécessite une inductance de 10 µH. Un noyau compact en ferrite 4F1 (type E-E) peut être dimensionné pour réaliser l'inductance. Avec un volume de 10 cm³, correspondant à une puissance spécifique de 100 W/cm³, la température calculée à cœur du noyau atteint 210°C, si l'on considère un mode d'évacuation de la chaleur par convection naturelle. Il est nécessaire d'augmenter le volume de l'inductance à 50 cm³ pour ramener l'échauffement à une valeur de 70°C acceptable pour le matériau.

Afin de réduire cet échauffement, il a été proposé d'améliorer l'échange thermique à la surface du noyau. Par exemple des systèmes de régulation thermique qui comprennent un échangeur thermique peuvent être mis en œuvre mais ils pénalisent la compacité du convertisseur et en augmentent le coût.

Il est également connu que de diminuer la perméabilité effective par la création d'entrefers dans le noyau est favorable pour diminuer le niveau d'induction et pour obtenir un échauffement réduit. Mais l'ajout d'entrefer provoque une augmentation de la taille du noyau et peut dégrader la compatibilité électromagnétique de l'inductance du fait du rayonnement du champ magnétique dans les entrefers.

Il a également été proposé de réaliser des inductances planaires dans lesquelles le noyau présente une épaisseur faible par rapport à sa longueur et sa largeur.

Le document US 9 001 524 décrit un circuit intégré comportant une inductance formant un cadre, le noyau est plan et a la forme d'un cadre bordant le support. Cette inductance occupe encore un espace important sur le support et les échanges thermiques ne sont pas optimisés.

Le document EP 1 495 475 décrit un élément de circuit magnétique comportant une plaque de circuit imprimé et un noyau magnétique et des bobinages entourant le noyau magnétique. Le noyau magnétique traverse la plaque de circuit imprimé.

### EXPOSÉ DE L'INVENTION

C'est par conséquent un but de la présente invention d'offrir un dispositif électronique comportant au moins un composant actif et au moins une inductance offrant une compacité élevée et une gestion thermique efficace.

Le but énoncé ci-dessus est atteint par un dispositif comprenant un support, au moins un composant actif fixé sur le support et au moins une inductance, l'inductance comportant un noyau magnétique et un conducteur entourant en partie le noyau, le noyau comportant un corps présentant une épaisseur inférieure par rapport à sa longueur. Le corps définit au moins en partie un chemin magnétique, et le corps comporte au moins une première portion et une deuxième portion successives définissant deux zones successives du chemin magnétique, la première portion étant en contact avec le support et la deuxième portion étant disposée par rapport au support de sorte à présenter un contact réduit avec celui-ci.

On entend par « chemin magnétique » dans la présente demande, le parcours suivi par les lignes de flux magnétique générées dans le noyau par le courant circulant dans le conducteur électrique entourant une partie du noyau. Le chemin magnétique parcourt un circuit magnétique fermé. Le circuit magnétique peut comporter des parties constituées par des matériaux différents, ces parties sont par exemple le noyau et le ou les entrefers, présentant chacune une section et une longueur propre.

Ainsi les surfaces de la deuxième portion, dont le contact est réduit avec le support, peuvent échanger plus efficacement de la chaleur et assurer le refroidissement du noyau. La gestion thermique du noyau est donc facilitée. En outre, la disposition de cette deuxième portion permet de libérer de la place pour d'autres composants à fixer sur le support et/ou de réduire la surface du support. Une partie du noyau occupe une zone au-dessus du support généralement délimitée par un boîtier et généralement inoccupé. Il est donc possible de rendre le dispositif plus compact tout en limitant la montée en température du noyau.

De manière très avantageuse, la deuxième portion du noyau est en contact thermique avec un élément, par exemple une plaque, présentant une grande surface encore plus efficace pour échanger de la chaleur par convection. La gestion thermique de l'inductance est encore améliorée. Le boîtier lui-même peut servir à évacuer la chaleur du noyau.

En d'autres termes, on réalise un dispositif dans lequel l'inductance comporte un noyau magnétique sous forme de bande(s) conformée(s) et/ou disposée(s) de sorte à former une structure tridimensionnelle, dont une partie n'est pas en contact avec le support pour augmenter la surface d'échange thermique, ce qui permet à la fois d'occuper des zones du dispositif non occupées et de gagner en compacité et de limiter l'échauffement du noyau.

Dans un exemple de réalisation, le noyau ferromagnétique comprend des parties planes de faible épaisseur permettant de réduire le volume du noyau, de favoriser les échanges thermiques et de réduire l'empreinte de l'inductance dans le convertisseur. Les parties planes formant le noyau sont assemblées ou liées entre elles de façon à former une structure tridimensionnelle de grande longueur et de faible section formant un circuit magnétique. La structure tridimensionnelle est telle qu'elle occupe un volume le plus faible possible dans le convertisseur en utilisant notamment les volumes disponibles.

La présente invention a alors pour objet un dispositif électronique tel que défini par la revendication 1.

De manière avantageuse, le rapport entre l'épaisseur et la longueur et le rapport entre l'épaisseur et la largeur sont inférieurs à 1/10.

Dans un exemple de réalisation, le noyau peut comporter un entrefer entre la première portion et la deuxième portion.

Le dispositif électronique peut comporter un boîtier monté sur le support, ledit boîtier et le support définissant un volume dans lequel sont logés le au moins un composant actif et l'inductance.

La moins la deuxième portion de l'inductance peut alors avantageusement être conformée pour s'adapter audit volume.

Dans un exemple de réalisation, la deuxième portion est intégrée dans une paroi du boîtier.

Dans un exemple très avantageux, le dispositif peut comporter au moins une plaque d'échange thermique connectée thermiquement au noyau. Par exemple le dispositif comporte au moins un élément conducteur thermique et isolant électrique en contact avec le noyau et avec la plaque d'échange thermique. La plaque d'échange thermique peut former au moins une partie d'une paroi du boîtier.

Dans un exemple de réalisation, le conducteur électrique forme un bobinage comportant une partie intégrée au support.

De préférence, le support est un circuit intégré.

La présente invention a également pour objet un convertisseur comportant au moins un dispositif électronique selon l'invention, le composant actif étant un transistor.

La présente invention a également pour objet un procédé de fabrication d'un dispositif électronique selon l'invention, comportant les étapes :
a) fourniture d'un support,
b) fourniture d'un composant actif et assemblage de celui-ci sur le support,
c) réalisation du noyau d'inductance,
d) montage du noyau sur le support,
e) fourniture et montage du bobinage.

Lors de l'étape c) des bandes destinées à former les première et deuxième portions peuvent être fabriquées, par exemple par coulage en bande d'une barbotine comportant de la poudre de matériau ferromagnétique ou par moulage par injection de poudre à partir d'un mélange-maître comportant du matériau ferromagnétique en bande.

On peut prévoir lors de l'étape c) de mettre en forme les bandes selon une forme souhaitée.

Lors de l'étape c), par exemple au moins une partie des bandes sont solidarisées les unes aux autres pour réaliser au moins une partie du noyau.

Lors de l'étape d), les bandes peuvent être assemblées de sorte à former le noyau.

Dans un exemple avantageux, une partie du bobinage est réalisée avant montage du noyau et l'autre partie est réalisée après montage du noyau.

### BRÈVE DESCRIPTION DES DESSINS

La présente invention sera mieux comprise sur la base de la description qui va suivre et des dessins en annexe sur lesquels:
- la figure 1 est une vue en perspective d'un exemple de réalisation d'un dispositif électronique selon l'invention,
- la figure 2 est une vue de dessus d'un détail de réalisation d'un dispositif électronique selon un autre exemple de réalisation,
- la figure 3 est une vue de côté de la figure 2.

### EXPOSÉ DÉTAILLÉ DE MODES DE RÉALISATION PARTICULIERS

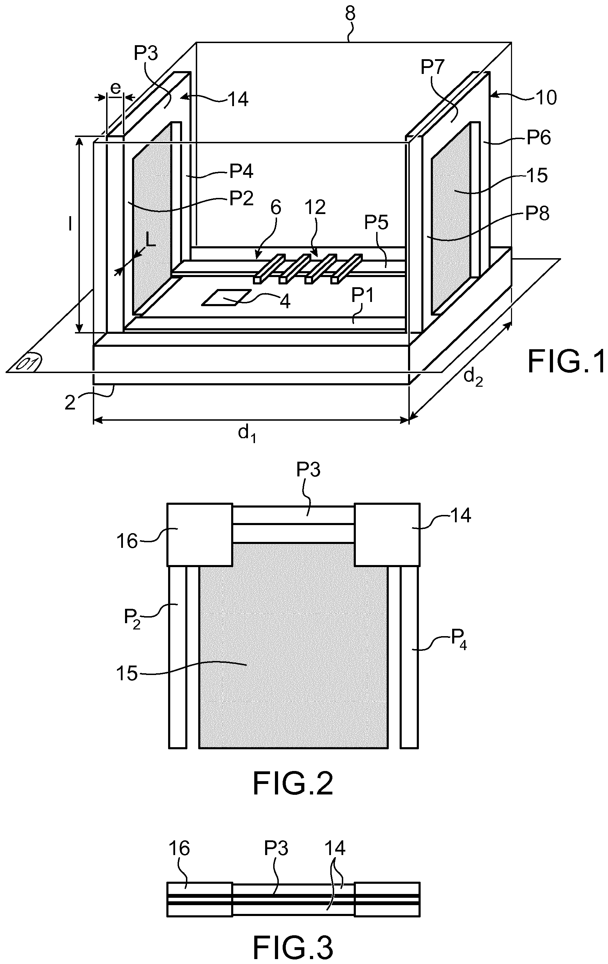

Sur la figure 1, on peut voir un exemple de dispositif électronique à inductance selon l'invention, par exemple un convertisseur de puissance.

Le dispositif de la figure 1 comporte un support 2, formé par un plaque rectangulaire de faible épaisseur, au moins un composant actif 4, par exemple un transistor, fixé sur le support 2, au moins une inductance 6 et un boîtier 8. Le support 2 s'étend dans un plan O1. Les dimensions du support dans le plan O1 sont désignées d1 et d2. Le support est par exemple un circuit intégré, et le au moins un composant actif 4 peut être réalisé de manière intégrée au circuit.

L'inductance 6 comporte un noyau magnétique 10 et un conducteur électrique 12 ou bobinage entourant au moins une partie du noyau 10.

Lorsqu'un courant circule dans le bobinage 12, des lignes de flux magnétique circulent dans le noyau selon un chemin magnétique. Dans le cas d'un noyau en forme de cadre rectangulaire, les lignes de flux magnétique forment des boucles fermées. Les lignes de flux magnétique s'écoulent le long du chemin magnétique qui s'étend sur toute la longueur du noyau.

Le noyau magnétique 10 comporte un corps 14 formé d'une bande continue ou d'une succession de bandes. Le corps du noyau est par exemple en ferrite spinelle, telle que NiZn et MnZn, par exemple en NiZn 4F1.

Chaque bande présente une épaisseur e, une largeur L et une longueur I. Le produit e × L correspond à la section du noyau qui est également la section magnétique A du noyau.

L'épaisseur e est très inférieure à la largeur L et à la longueur l, de préférence au moins d'un facteur 10.

Ces proportions dans les dimensions des bandes facilitent l'intégration du noyau car les bandes minces ainsi formées peuvent être conformées, par exemple cintrées ou embossées, de façon à épouser des surfaces non planes, ce qui n'est pas réalisable avec des barreaux plus épais.

A titre d'exemple, e est comprise entre 1 mm et 5 mm, L est compris entre 5 mm et 20 mm et l est compris entre 50 mm et 200 mm, et e/L = 1/10 et e/l = 1/100.

On peut envisager que les dimensions du noyau varie le long du chemin magnétique, i.e. l'épaisseur et/ou la largeur.

La ou les bandes comporte(nt) une surface latérale qui, dans le cas d'une bande de forme parallélépipédique rectangle, comporte deux surfaces rectangulaires de plus grande aire égale à L×l et deux surfaces rectangulaires de plus petite aire égale à e×l.

Dans l'exemple représenté sur la figure 1, le corps 14 du noyau comporte huit portions droites désignées P1, P2, P3, P4, P5, P6, P7, P8. Les huit portions délimitent une boucle dans laquelle circulent les lignes de flux magnétique. Dans l'exemple représenté, les huit portions sont droites et s'étendent selon un axe longitudinal et comporte chacune deux extrémités longitudinales.

Dans l'exemple représenté, les portions P1 et P5 sont en contact avec le support 2 par une partie de leur surface latérale. Dans l'exemple représenté, les portions P1 et P5 sont en contact avec le support par l'une des surfaces de plus grande aire.

En variantes, les portions P1 et P5 du noyau en contact avec le support pourraient reposées sur le support par une de leurs surfaces de plus petite aire.

Les portions P1 et P2 assurent d'une part la fixation de l'inductance sur le support et d'autre part la connexion électrique avec les autres composants du dispositif. Dans l'exemple représenté, la disposition de la portion P5 permet en outre de réaliser le bobinage de manière intégrée au support. Le bobinage 12 est disposé autour d'une partie de la portion P5, sa réalisation sera décrite ci-dessous. Cette réalisation intégrée permet encore de réduire l'encombrement de l'inductance. Mais il sera compris qu'une inductance dont le bobinage est formé d'un fil conducteur continu entourant notamment au moins une des portions parmi les portions P2 à P4 et P6 à P8 ne sort pas du cadre de la présente invention

Les portions P1 et P5 sont disposés parallèlement l'une par rapport à l'autre et s'étendent sur toute la dimension d1 du support.

Les portions P2, P3, P4 sont disposées les unes par rapport aux autres de sorte à former un U retourné, P3 formant le fond U et les portions P2 et P4 formant les montants du U. Le U ainsi formé est disposé dans un plan orthogonal au plan O1. Le U est disposé par rapport aux portions P1 et P5 de sorte que les montants du U se raccordent aux portions P1 et P5. Les portions P6, P7 et P8 présentent une configuration similaire à celles des portions P2, P3 et P4 et sont disposées dans un plan orthogonal au plan O1 et parallèle au plan contenant les portions P2, P3 et P4.

De préférence, un entrefer est prévu entre deux portions de noyau successives. La réalisation de l'inductance est simplifiée puisque le noyau peut être réalisé à partir de portions planes. En variante, on pourrait prévoir que certaines des portions soient en contact les unes avec les autres, voire que toutes les portions soient en contact formant un noyau fermé. En variante encore, l'entrefer ou les entrefers pourraient être prévus dans la portion P1 et/ou la portion P5.

Les surfaces latérales des portions P2, P3, P4 et P6, P7, P8 ne sont pas en contact avec le support et peuvent échanger thermiquement par convection avec l'environnement extérieur. Le noyau présente alors une très grande surface d'échange thermique, puisqu'elle comporte les surfaces latérale complètes des portions P2, P3, P4 et P6, P7, P8 et une grande partie des surfaces latérales des portions P1 et P5. Il est à noter que la partie des surfaces latérales des portions P1 et P5 en contact avec le support échange par conduction avec le support et participe au refroidissement du noyau.

En outre, le noyau occupe une partie du volume situé au-dessus du support, ce qui permet de libérer de la place sur le support ou alors de réduire la surface du support. De manière avantageuse, le noyau est conformé pour s'adapter au volume intérieur du boîtier, occupant ainsi des volumes généralement inutilisés.

Dans une variante très avantageuse, on peut prévoir que les parois du boîtier soient conformées pour loger une partie du noyau. Par exemple les portions P2, P3, P4 et P6, P7, P8 peuvent être intégrées dans l'épaisseur des parois du boîtier, réduisant encore davantage l'encombrement spatial du noyau et favorisant les échanges thermiques avec l'extérieur.

Le bobinage est par exemple réalisé en formant un premier demi-bobinage dans un substrat, une portion du noyau sur le premier demi-bobinage et un deuxième demi-bobinage sur la portion de noyau de sorte à former un bobinage complet, par exemple en utilisant les techniques de la microélectronique. Un exemple d'un tel procédé est par exemple décrit dans le document US2009/0160595. Une telle inductance présence un encombrement davantage réduit.

Il sera compris que le nombre et la forme des portions peuvent varier. Le nombre de portions dont une partie de la paroi latérale est en contact avec le support peut également varier. Toutes les portions ou une partie d'entre elles pourraient être par exemple courbées. On pourrait envisager de réaliser un corps de noyau d'un seul tenant directement de forme tridimensionnelle.

En outre la disposition relative des portions les unes par rapport aux autres peut également varier. Par exemple les portions dont la paroi latérale n'est pas en contact avec le support peuvent être inclinées par rapport au plan du support.

De préférence, la forme du corps est telle que sa projection sur le plan O1 est contenue dans la projection du support de sorte pouvoir intégrer tout le dispositif dans un boîtier recouvrant le support.

Dans l'exemple représenté, le noyau est symétrique par rapport à un plan orthogonal au plan O1, mais ceci n'est en aucun cas limitatif, on pourrait prévoir toute autre forme permettant d'offrir un chemin magnétique long et occupant au mieux l'espace au-dessus du support.

Dans un exemple avantageux on peut prévoir de coupler des portions du noyau avec des moyens d'échange thermique permettant d'évacuer encore davantage la chaleur générée dans le noyau.

Sur les figures 2 et 3, on peut voir un exemple de réalisation d'un détail d'un noyau mettant en œuvre de tels moyens.

Dans cet exemple, on peut voir une partie du noyau en forme de U formée par les portions P2, P3, P4. Des plaques 15 sont disposées de part et d'autre du U à l'intérieur de l'espace délimité par le U. Les plaques 15 sont en un matériau offrant une très bonne conductivité thermique, tel que l'AIN qui présente de faibles propriétés de conductivité électrique, ou en cuivre.

Dans l'exemple représenté, les dimensions extérieures des plaques et les dimensions intérieures du U sont telles qu'il n'y a pas de contact entre les plaques et les portions P1, P2, P3. Des éléments conducteurs thermiques et isolants électriques 16, par exemple en AIN, sont prévus pour relier thermiquement les portions et les plaques. Le jeu entre les plaques 15 et les portions permet par exemple de disposer un bobinage autour de l'un des montants.

Les éléments conducteurs thermiques et isolants électriques permettent d'éviter les fuites de flux près du noyau qui pourraient créer des courants induits.

Ainsi la chaleur générée dans le noyau est transmise aux plaques d'échange thermique par conduction à travers les éléments 16 et la chaleur est ensuite évacuée par convection.

Dans le cas où les plaques d'échange thermique sont en en matériau isolant électrique, un contact direct entre le noyau et les plaques d'échange thermique peut être prévu comme cela est représenté sur la figure 1, l'évacuation de la chaleur se faisant directement du noyau vers les plaques d'échange thermique.

Dans l'exemple représenté, les plaques d'échange thermique sont disposées à l'intérieur de l'espace délimité par les portions du noyau de sorte que les bords des plaque soit en regard de la face latérale des tronçons, mais on pourrait prévoir que ce soit l'une des faces de la plaque qui soit en regard, voire en contact direct, avec les portions du noyau. En variante, une seule plaque 15 pourrait être mise en œuvre.

Comme cela est représenté sur la figure 1, la plaque d'échange thermique peut par exemple être intégrée au boîtier, par exemple peut former une partie d'une paroi du boîtier. Ainsi, l'échange thermique par convection est amélioré.

Selon un exemple avantageux, on pourrait prévoir également une ou des plaques d'échange thermique en contact thermique avec les portions P1 et P5 qui reposent sur le support afin d'augmenter la surface d'échange vers l'extérieur tout en drainant mieux la chaleur du noyau car le contact entre les plaques et le noyau est plus grand. Une plaque peut par exemple être en contact avec la face latérale des portions opposée à celle en contact avec le support. On peut prévoir de réaliser des fenêtres dans la ou les plaques pour permettre le passage d'autres composants. Ces plaques peuvent être profilées pour augmenter l'échange thermique. En variante, une plaque pourrait être disposée de part et d'autres des portions P1 et P5.

De manière très avantageuse, on peut prévoir des ailettes sur la surface latérale des portions et/ou sur le boîtier pour augmenter encore davantage les échanges thermiques. De manière préférée, les ailettes sont orientées de sorte à ce qu'elles soient sensiblement parallèles aux lignes de flux magnétique.

A titre de comparaison, un convertisseur DC/DC de 1kW élévateur de tension (200/400 V) nécessite une inductance de stockage de 10 µH pour un fonctionnement à 5 MHz. Cette inductance peut être obtenue avec un assemblage de deux composants ferromagnétiques standard de type E de l'état de la technique occupant un volume total de 50 cm³ et présentant une surface d'échange de 200 cm². Il existe d'autres formes de noyaux de volumes plus faibles mais ils présentent également des surfaces d'échange thermique plus faibles, leur mise en œuvre aurait pour effet d'augmenter la température de fonctionnement de l'inductance.

Grâce à l'invention, on peut réaliser le même convertisseur avec un noyau ayant un volume de 10 cm³ tout en conservant une surface d'échange thermique de 200 cm². Par exemple, le noyau comporte alors des bandes d'épaisseur e de 4 mm et de largeur L de 9 mm. La longueur totale l requise du circuit magnétique est de 300 mm. Le noyau peut être réalisé par la juxtaposition de dix bandes de longueur identique de 30 mm disposées de façon à former le circuit de la figure 1. Les surfaces latérales et inférieures permettent de développer la surface d'échange totale de 200 cm².

Des procédés de fabrication d'un dispositif selon l'invention vont maintenant être décrits.

Le procédé de fabrication comporte les étapes
a) fourniture d'un support,
b) fourniture d'un composant actif et assemblage de celui-ci sur le support,
c) réalisation du noyau d'inductance,
d) montage du noyau sur le support,
e) fourniture et montage du bobinage.

L'étape a) peut comporter l'étape de fabrication du support par exemple l'étape de fabrication d'un circuit intégré.

L'étape b) peut être confondue avec l'étape a), notamment lorsque le support est un circuit intégré, le composant actif qui est par exemple un transistor, peut être réalisé simultanément au circuit intégré.

L'étape c) peut comprendre les étapes d) et e).

Les portions du noyau peuvent être avantageusement réalisées par un procédé de coulage en bande qui est particulièrement adapté pour réaliser des pièces de faibles épaisseurs, par exemple de l'ordre du mm.

Il met en œuvre une préparation comportant des poudres de matériau ferromagnétique dispersées dans des solvants et liants organiques. Cette préparation est appelée barbotine. La barbotine est étalée sur un support plan, par exemple à l'aide d'un sabot comprenant une lame. Le mouvement de la lame produit un cisaillement et un nivellement de la barbotine déposée en lui conférant une bonne planéité et homogénéité. L'épaisseur de la bande ainsi formée peut-être contrôlée par un réglage de la hauteur de la lame. La bande ainsi formée est ensuite soumise à différents traitements d'évaporation et de séchage afin d'éliminer une partie des solvants. Ce procédé de coulage en bande est connu de l'homme du métier. A ce stade, la bande est souple et manipulable. Elle peut notamment être découpée selon un motif particulier avec des outils de découpe classiques.

On peut également prévoir à ce stade de plier ou courber la bande sur un support qui lui imprime un profil.

Dans la présente invention, on peut former certaines portions du noyau de la sorte. Par exemple, on utilise un gabarit, par exemple en alumine, qui présente le profil souhaité. Le gabarit est par exemple réalisé par usinage. La bande est déposée sur le gabarit puis est cintrée par une action mécanique pour en épouser la forme. L'ensemble est soumis à un traitement thermique à haute température produisant le frittage de la bande. Le frittage s'accompagnant d'un retrait volumique de l'ordre de 10%-15% dans toutes les directions du matériau, le découpage de la bande crue et les dimensions du gabarit tiennent compte de ce retrait.

Dans une variante de réalisation, la bande comprenant le matériau ferromagnétique peut être assemblée et soudée à d'autres bandes constituées d'un matériau différent dont les propriétés sont déterminées de façon à réaliser une partie des éléments de conduction thermique et du bobinage. L'ensemble est ensuite cofritté pour réaliser tout ou partie de l'inductance.

Selon un autre exemple de réalisation, les portions du noyau d'inductance sont réalisées par moulage par injection de poudres (ou PIM pour Powder Injection Molding en terminologie anglo-saxonne).

Dans un procédé PIM, la première étape consiste à obtenir un mélange-maître (ou "feedstock" en terminologie anglo-saxonne) adapté à l'application visée. Les mélanges-maîtres sont constitués d'un mélange de matière organique (ou liant polymérique) et des poudres inorganiques (métalliques ou céramiques) qui vont constituer la pièce finale. Ensuite, le mélange-maître s'injecte comme un matériau thermoplastique dans une presse à injecter selon une technologie connue de l'homme du métier. Le moulage permet de faire fondre les polymères injectés avec la poudre dans une cavité et donner la forme voulue au mélange. Au cours du refroidissement le mélange solidifie et conserve la forme donnée par le moule.

Après démoulage, la pièce est soumise à différent traitements thermiques ou chimiques afin de retirer les phases organiques. L'élimination de la phase organique lors de cette étape, appelée déliantage, laisse place à une porosité de 30% à 50% dans l'ébauche. Le brevet US 8940816 B2 décrit une méthode de préparation d'un mélange-maître et de déliantage dans le cas de la fabrication par PIM.

A l'issue du déliantage l'ébauche poreuse ne contient que les poudres du matériau inorganique. Cette ébauche est ensuite densifiée pour former la pièce dense finale. La consolidation des ébauches poreuses est réalisée par un frittage à haute température, par exemple supérieure à 1000°C effectué dans des fours fonctionnant sous une atmosphère adaptée au type de matériau utilisé. Lorsque que la densité optimale est atteinte, la pièce est refroidie jusqu'à la température ambiante.

Lors de l'étape c) on peut soit réaliser des bandes droites qui seront ensuite assemblées les unes aux autres et/ou disposées les unes par rapport aux autres pour former le noyau tridimensionnel selon l'invention, soit réaliser un noyau d'un seul tentant comprenant une portion au moins pour le montage du noyau sur le support.

Les bandes frittées forment à ce stade des composants rigides qui peuvent être manipulés. Ces composants sont particulièrement stables et peuvent être exposés à des contraintes mécaniques, par exemple de l'ordre de plusieurs MPa, à des élévations de température, par exemple de l'ordre de plusieurs centaines de degrés. Les bandes peuvent être assemblées par exemple par collage, par exemple au moyen d'une colle conductrice thermique. Par exemple, les bandes peuvent être assemblées et insérées dans des logements de forme correspondante prévues dans le support et/ou le boitier.

Ces logements peuvent être par exemple réalisés par moulage lorsque le boîtier et/ou le support sont en matériau plastique. Les bandes peuvent être maintenues en position par des moyens mécaniques, par exemple par sertissage, ou par collage, par exemple au moyen d'une résine époxy.

L'étape e) peut être réalisée selon la technique décrite dans le document US2009/0160595 décrit ci-dessus. Dans ce cas, les étapes d) et e) sont simultanées.

La présente invention est particulièrement adaptée à la réalisation de convertisseurs de puissance compacts et fonctionnant à hautes fréquences, car l'inductance permet de limiter de manière très efficace l'échauffement du noyau.

## Revendications

1. Dispositif électronique comportant un support (2), au moins un composant actif (4) et au moins une inductance (6), ladite inductance (6) comportant un noyau magnétique (10) et un conducteur électrique (12) entourant au moins une partie du noyau magnétique, le noyau magnétique (10) délimitant au moins une partie d'un chemin magnétique le long duquel des lignes de flux magnétiques sont destinées à s'écouler, dans lequel le noyau magnétique (10) est disposé d'un côté du support (2), et comporte au moins une première portion (P1, P5) et une deuxième portion (P2, P4, P6, P8) définissant deux zones successives du chemin magnétique, chaque première portion (P1, P5) et deuxième portion (P2, P4, P6, P8) ayant une forme de bande présentant une épaisseur inférieure par rapport à sa longueur et à sa largeur, chaque première portion (P1, P5) et deuxième portion(P2, P4, P6, P8) comportant une surface latérale par rapport à une direction du chemin magnétique, la première portion (P1, P5) étant en contact direct avec le support par une partie de sa surface latérale et étant entourée par le conducteur électrique (12), la deuxième portion (P2, P4, P6, P8) étant disposée par rapport au support (2) de sorte que sa surface latérale soit libre de contact avec le support (2), dans lequel, pour chacune des première (P1, P5) et deuxième (P2, P4, P6, P8) portions, un rapport de l'épaisseur sur la longueur est compris entre 1/200 et 1/10 et un rapport de l'épaisseur sur la largeur est compris entre 1/20 et 1.

2. Dispositif électronique selon la revendication 1, dans lequel, pour chacune des portions, le rapport entre l'épaisseur et la longueur et le rapport entre l'épaisseur et la largeur sont inférieurs au moins à 1/10.

3. Dispositif électronique selon la revendication 1 ou 2, dans lequel le noyau magnétique (10) comporte un entrefer entre la première portion (P1, P5) et la deuxième portion (P2, P4, P6, P8).

4. Dispositif électronique selon l'une des revendications 1 à 3, comportant un boîtier (8) monté sur le support (2), ledit boîtier (8) et le support (2) définissant un volume dans lequel sont logés le au moins un composant actif (4) et l'inductance (6).

5. Dispositif électronique selon la revendication 4, dans lequel la deuxième portion (P2, P4, P6, P8) est intégrée dans une paroi du boîtier (8).

6. Dispositif électronique selon l'une des revendications 1 à 5, comportant au moins une plaque d'échange thermique (15) connectée thermiquement au noyau magnétique (10).

7. Dispositif électronique selon la revendication 6, comportant au moins un élément conducteur thermique (16) et isolant électrique en contact avec le noyau magnétique (10) et avec la plaque d'échange thermique (15).

8. Dispositif électronique selon la revendication 6 ou 7 en combinaison avec la revendication 4, dans lequel la plaque d'échange thermique (15) forme au moins une partie d'une paroi du boîtier (8).

9. Dispositif électronique selon l'une des revendications 1 à 8, dans lequel le conducteur électrique (12) forme un bobinage comportant une partie intégrée au support (2).

10. Dispositif électronique selon l'une des revendications 1 à 9, dans lequel le support (2) est un circuit intégré.

11. Convertisseur comportant au moins un dispositif électronique selon l'une des revendications 1 à 10, le composant actif étant un transistor.

12. Procédé de fabrication d'un dispositif électronique selon l'une des revendications 1 à 10, comportant les étapes :
a) fourniture d'un support,
b) fourniture d'un composant actif et assemblage de celui-ci sur le support,
c) réalisation du noyau magnétique,
d) montage du noyau magnétique sur le support,
e) fourniture et montage du bobinage.

13. Procédé de fabrication selon la revendication 12, dans lequel lors de l'étape c) des bandes destinées à former les première et deuxième portions sont fabriquées, avantageusement par coulage en bande d'une barbotine comportant de la poudre de matériau ferromagnétique ou par moulage par injection de poudre à partir d'un mélange-maître comportant du matériau ferromagnétique en bande, avantageusement lors de l'étape c), les bandes sont mises sous une forme souhaitée.

14. Procédé de fabrication selon la revendication 13, dans lequel lors de l'étape c), au moins une partie des bandes sont solidarisées les unes aux autres pour réaliser au moins une partie du noyau magnétique.

15. Procédé de fabrication selon l'une des revendications 13 ou 14, dans lequel lors de l'étape d) les bandes sont assemblées de sorte à former le noyau magnétique et/ou dans lequel une partie du bobinage est réalisée avant montage du noyau magnétique et l'autre partie est réalisée après montage du noyau magnétique.

## Patentansprüche

1. Elektronische Vorrichtung, umfassend einen Träger (2), wenigstens eine aktive Komponente (4) und wenigstens einen Induktor (6), wobei der Induktor (6) einen magnetischen Kern (10) und einen elektrischen Leiter (12) umfasst, der wenigstens einen Teil des magnetischen Kerns umgibt, wobei der magnetische Kern (10) wenigstens einen Teil eines magnetischen Pfads begrenzt, entlang dessen magnetische Flusslinien fließen sollen, wobei der magnetische Kern (10) auf einer Seite des Trägers (2) angeordnet ist und wenigstens einen ersten Bereich (P1, P5) und einen zweiten Bereich (P2, P4, P6, P8) umfasst, die zwei aufeinander folgende Zonen des magnetischen Pfads definieren, wobei jeder erste Bereich (P1, P5) und zweite Bereich (P2, P4, P6, P8) eine Form eines Bands hat, das eine geringere Dicke bezogen auf seine Länge und seine Breite aufweist, wobei jeder erste Bereich (P1, P5) und zweite Bereich (P2, P4, P6, P8) bezogen auf eine Richtung des magnetischen Pfads eine laterale Oberfläche umfasst, wobei der erste Bereich (P1, P5) in direktem Kontakt mit dem Träger mittels eines Teils seiner lateralen Oberfläche ist und von dem elektrischen Leiter (12) umgeben ist, wobei der zweite Bereich (P2, P4, P6, P8) bezogen auf den Träger (2) derart angeordnet ist, dass seine laterale Oberfläche frei von Kontakt mit dem Träger (2) ist, wobei für jeden von den ersten (P1, P5) und zweiten (P2, P4, P6, P8) Bereichen ein Verhältnis der Dicke zur Länge zwischen 1/200 und 1/10 enthalten ist, und ein Verhältnis der Dicke zur Breite zwischen 1/20 und 1 enthalten ist.

2. Elektronische Vorrichtung nach Anspruch 1, bei der für jeden der Bereiche das Verhältnis zwischen der Dicke und der Länge und das Verhältnis zwischen der Dicke und der Breite wenigstens kleiner als 1/10 ist.

3. Elektronische Vorrichtung nach Anspruch 1 oder 2, bei der der magnetische Kern (10) einen Luftspalt zwischen dem ersten Bereich (P1, P5) und dem zweiten Bereich (P2, P4, P6, P8) umfasst.

4. Elektronische Vorrichtung nach einem der Ansprüche 1 bis 3, umfassend ein Gehäuse (8), das auf dem Träger (2) montiert ist, wobei das Gehäuse (8) und der Träger (2) ein Volumen definieren, in dem die wenigstens eine aktive Komponente (4) und der Induktor (6) aufgenommen sind.

5. Elektronische Vorrichtung nach Anspruch 4, bei der der zweite Bereich (P2, P4, P6, P8) in einer Wand des Gehäuses (8) integriert ist.

6. Elektronische Vorrichtung nach einem der Ansprüche 1 bis 5, umfassend wenigstens eine Wärmetauschplatte (15), die thermisch mit dem magnetischen Kern (10) verbunden ist.

7. Elektronische Vorrichtung nach Anspruch 6, umfassend wenigstens ein thermisch leitendes und elektrisch isolierendes Element (16) in Kontakt mit dem magnetischen Kern (10) und mit der Wärmetauschplatte (15).

8. Elektronische Vorrichtung nach Anspruch 6 oder 7 in Kombination mit Anspruch 4, bei der die Wärmetauschplatte (15) wenigstens einen Teil einer Wand des Gehäuses (8) bildet.

9. Elektronische Vorrichtung nach einem der Ansprüche 1 bis 8, bei der der elektrische Leiter (12) eine Wicklung bildet, die einen mit dem Träger (2) integrierten Teil umfasst.

10. Elektronische Vorrichtung nach einem der Ansprüche 1 bis 9, bei der der Träger (2) eine integrierte Schaltung ist.

11. Wandler, umfassend wenigstens eine elektronische Vorrichtung nach einem der Ansprüche 1 bis 10, wobei die aktive Komponente ein Transistor ist.

12. Verfahren zur Herstellung einer elektronischen Vorrichtung nach einem der Ansprüche 1 bis 10, umfassend die folgenden Schritte:
a) Bereitstellen eines Trägers,
b) Bereitstellen einer aktiven Komponente und Anbringen derselben an dem Träger,
c) Herstellen des magnetischen Kerns,
d) Montieren des magnetischen Kerns an dem Träger,
e) Bereitstellen und Montieren der Wicklung.

13. Herstellungsverfahren nach Anspruch 12, bei der während des Schritts c) Bänder hergestellt werden, die dazu ausgelegt sind, den ersten und den zweiten Bereich zu bilden, vorzugsweise durch Bandvergießen einer Schlämme, die Pulver eines ferromagnetischen Materials umfasst, oder durch Spritzgießen eines Pulvers ausgehend von einem Masterbatches, die ferromagnetisches Material umfasst, als Band, wobei vorzugsweise während des Schritts c) die Bänder in eine gewünschte Form gebracht werden.

14. Herstellungsverfahren nach Anspruch 13, bei dem während des Schritts c) wenigstens ein Teil der Bänder miteinander verbunden werden, um wenigstens einen Teil des magnetischen Kerns zu realisieren.

15. Herstellungsverfahren nach einem der Ansprüche 13 oder 14, bei dem während des Schritts d) die Bänder derart zusammengefügt werden, dass sie den magnetischen Kern bilden, und/oder bei dem ein Teil der Wicklung vor der Montage des magnetischen Kerns realisiert wird und der andere Teil nach der Montage des magnetischen Kerns realisiert wird.

## Claims

1. Electronic device comprising a carrier (2), at least one active component (4) and at least one inductor (6), said inductor (6) comprising a magnetic core (10) and an electrical conductor (12) surrounding at least part of the magnetic core, the magnetic core (10) delimiting at least a part of a magnetic path along which magnetic flux lines will flow, in which the magnetic core (10) is located on one side of the carrier (2), and comprises at least one first portion (P1, P5) and one second portion (P4, P4, P6, P8) defining two successive zones of the magnetic path, each first portion (P1, P5) and second portion (P4, P4, P6, P8) having a shape of strip with a thickness smaller than its length and its width, each first portion (P1, P5) and second portion (P2, P4, P6, P8) comprising a lateral surface relative to a direction of the magnetic path, the first portion (P1, P5) being in direct contact with the carrier through part of its lateral surface and being surrounded by the electrical conductor (12), the second portion (P4, P4, P6, P8) being located relative to the carrier (2) such that its lateral surface does not come into contact with the carrier (2), in which for each of the first (P1, P5) and second (P4, P4, P6, P8) portions, a thickness to length ratio is between 1/200 and 1/10 and a thickness to width ratio is between 1/20 and 1.

2. Electronic device according to claim 1, in which for each portion, the ratio between the thickness and the length and the ratio between the thickness and the width are less than at least 1/10.

3. Electronic device according to claim 1 or 2, in which the magnetic core (10) comprises an air gap between the first portion (P1, P5) and the second portion (P4, P4, P6, P8).

4. Electronic device according to one of claims 1 to 3, comprising a package (8) mounted on the carrier (2), said package (8) and the carrier (2) defining a volume in which the at least one active component (4) and the inductor (6) are housed.

5. Electronic device according to claim 4, in which the second portion (P4, P4, P6, P8) is integrated into a wall of the package (8).

6. Electronic device according to one of claims 1 to 5, comprising at least one heat exchange plate (15) thermally connected to the magnetic core (10).

7. Electronic device according to claim 6, comprising at least one heat conducting and electrically insulating element (16) in contact with the magnetic core (10) and with the heat exchange plate (15).

8. Electronic device according to claim 6 or 7 in combination with claim 4, in which the heat exchange plate (15) at least partly forms a wall of the package (8).

9. Electronic device according to one of claims 1 to 8, in which the electrical conductor (12) forms a winding containing a part integrated into the carrier (2).

10. Electronic device according to one of claims 1 to 9, in which the carrier (2) is an integrated circuit.

11. Converter comprising at least one electronic device according to one of claims 1 to 10, in which the active component is a transistor.

12. Method of manufacturing an electronic device according to one of claims 1 to 10, including the following steps:
a) supply a carrier,
b) supply an active component and assemble it on the carrier,
c) fabricate the magnetic core,
d) assemble the magnetic core on the carrier,
e) supply and assemble the winding.

13. Manufacturing method according to claim 12, in which during step c), strips intended to form the first and second portions are fabricated, advantageously by pouring a strip of a slurry containing ferromagnetic material powder or by injection moulding of powder from a feedstock comprising the strip of ferromagnetic material, advantageously during step c), the strips being put into a required shape.

14. Manufacturing method according to claim 13, in which during step c), at least part of the strips are fixed to each other to make a part of the magnetic core.

15. Manufacturing method according to claim 13 or 14, in which during step d), the strips are assembled to form the magnetic core, and/or in which part of the winding is made before the magnetic core is assembled and the other part is made after the magnetic core has been assembled.
